Europäisches Patentamt

European Patent Office

Office européen des brevets

(11) Publication number: **0 095 367**
**B1**

# EUROPEAN PATENT SPECIFICATION

(45) Date of publication of patent specification: **04.01.89**

(21) Application number: **83302950.7**

(22) Date of filing: **23.05.83**

(51) Int. Cl.⁴: **H 01 J 37/18, H 01 J 37/317**

(54) **Rapid pumpdown for high vacuum processing.**

(30) Priority: **24.05.82 US 381288**

(43) Date of publication of application:
**30.11.83 Bulletin 83/48**

(45) Publication of the grant of the patent:
**04.01.89 Bulletin 89/01**

(84) Designated Contracting States:
**CH DE FR GB LI NL**

(56) References cited:
**FR-A-2 330 140**
**GB-A-1 098 289**

**SOLID STATE TECHNOLOGY, vol. 18, no. 12,
December 1975, pages 41-45, Port Washington,
N.Y., US; A.B. WITTKOWER et al.: "Advances in
ion implantation production equipment"**

**IBM TECHNICAL DISCLOSURE BULLETIN, vol.
11, no. 7, December 1968, pages 781-782,
Armonk, N.Y., US; P. PILEUR: "Transient trap
for retaining water vapor"**

(73) Proprietor: **VARIAN ASSOCIATES, INC.**
**611 Hansen Way**
**Palo Alto, CA 94303 (US)**

(72) Inventor: **Holden, Scott Carleton**
**University Lane**
**Manchester Massachusetts 01944 (US)**
Inventor: **Turner, Norman Leonard**
**44 Riverview Road**
**Gloucester Massachusetts 01930 (US)**

(74) Representative: **Cline, Roger Ledlie et al**
**EDWARD EVANS & CO. Chancery House 53-64**
**Chancery Lane**
**London WC2A 1SD (GB)**

## Description

The present invention relates to high vacuum processing, particularly for the purpose of semiconductor processing by ion implantation equipment.

In the context of high volume treatment of semiconductor wafers by ion implantation and similar processes, it is necessary to introduce semiconductor wafers from ambient atmosphere to an end station of an ion implanter for processing under high vacuum conditions. Throughput, the volume of wafers processed per unit time, is limited in such processing by the time required to make the transition from ambient pressure to high vacuum. Pressure reduction is accomplished in two major steps; reduction to rough vacuum is ordinarily accomplished by mechanical displacement pumps which are then valved off; high vacuum pumps are then placed in the open communication with the processing chamber and workpieces.

Straightforward refinements to these operations include provision of small volume vacuum lock chambers wherein the main portion of the chamber remains constantly at high vacuum, while the smaller volume region containing the workpiece(s) is pumped to rough vacuum. The lock is then isolated from the roughing system and a valve separating the lock from the main chamber is then opened.

The evacuation of residual atmospheric gasses ($H_2$, $N_2$, $O_2$, $CO_2$ and inert gasses) proceeds at a predictable exponential rate. The rapid evacuation of these gasses is not generally the determining factor for the time interval required to reduce the pressure in a processing situation as described. This occurs because the surfaces of the workpiece which has been introduced to the chamber from atmosphere invariably appear as a virtual leak through the gradual release of molecules from the surfaces through a process known as outgassing. Outgassing rates vary in linear proportion to the surface area and inversely with time for such exemplary surfaces as typical metals. For polymers the time behavior typically follows an inverse square root dependence. A major contribution to the outgassing contribution to system pressure is attributed to water vapor which by its polar properties tends to persist in equilibrium with the workpiece surfaces.

It is known in the prior art to split the workpiece stream into two channels and to accomplish the "roughing out" pumpdown in one channel while final pumpdown to high vacuum and processing occurs in the other channel. This parallel processing mode does not obviate the limits imposed by the pumping processing itself.

In the prior art, the time interval for pressure reduction to high vacuum was decreased by increasing the pumping speed of the high vacuum pump. The pumping speed is a figure of merit which quantifies the volume of vapor per unit time which is displaced or captured by the pump. Increased physical size, capital and operating expense are concomitants of higher pumping speed and thus effect the economy of the operation.

It is known that pumping speed varies with the specific gas or gasses pumped.

The processing chamber pressure experienced during ion implantation processing necessarily affects the measurement of "dose", the integrated charge deposited in the wafer. This is conveniently achieved by situating the workpiece in a Faraday cage from which the current to ground is then measured. When the pressure is sufficiently high for ionization of the residual gasses (neutralization of the beam) to become appreciable due to the transmitted beam, the charge collection is, to that extent, a less accurate measure of the actual charged particle beam flux represented by the Faraday cage current integration.

The present invention is based upon the observation that the time dependence of the pressure reduction for a cyclic processing environment has a first component which is exponential in time and depends on system properties independent of the processing steps. A second component depends upon the character of the workpiece which due to its importation from atmosphere brings with it a substantial $H_2O$ outgassing. The time dependence may be stated as

$$P(t) = \Delta p \left( \exp\left( \frac{-tV_0}{S_0} \right) + \frac{Q_0}{S_0} \right) + \frac{(Q/A)_w}{S_{H_2O}(t)} + \frac{(Q/A)_p}{S_{H_2O}\sqrt{t}}$$

where

$P(t)$ = the time dependent pressure of the processing chamber (Pa)
$\Delta p$ = a pressure change due to the opening of a vacuum lock (Pa)
$t$ = time elapsed from the opening of the vacuum lock (seconds)
$S_0$ = total average pumping speed of the system for air (liters/sec.)
$V_0$ = volume of process chamber (liters)
$SH_2O$ = pumping speed for $H_2O$
$(Q/A)_w$ = outgassing constant for (uncoated) workpiece surface (Pa liter/cm$^2$)
$(Q/A)_p$ = outgassing constant for polymer coating on workpiece (Pa liter/cm$^2$ sec 1/2)
$A_w$ = exposed surface area of workpiece (cm$^2$)
$A_p$ = surface area of polymer (cm$^2$)
$Q_o$ = baseline equilibrium outgassing rate for process chamber interior surfaces (Pa liter/sec)

2

The right-hand side of the equation expresses a time independent term (the base line pressure) and an exponentially decaying term representing the pumping of atmospheric gasses (other than water vapor) from the chamber following an instantaneous pressure pulse at t = 0 (the opening of the vacuum lock at rough vacuum). The remaining terms express the time dependence in removal of $H_2O$ from the residual gasses. The different time dependences originate in the surface effects with respect to water vapor for the workpiece including any polymer coatings thereon, or other polymers present (o-rings, etc.).

According to the invention there is provided a cyclic processing system for charged particle radiation treatment of a plurality of objects in series as set out in claim 1 of the claims of this specification.

An example of the invention will now be described with reference to the accompanying drawings in which:—

FIG. 1 is a schematic illustration of a typical ion implantation system.

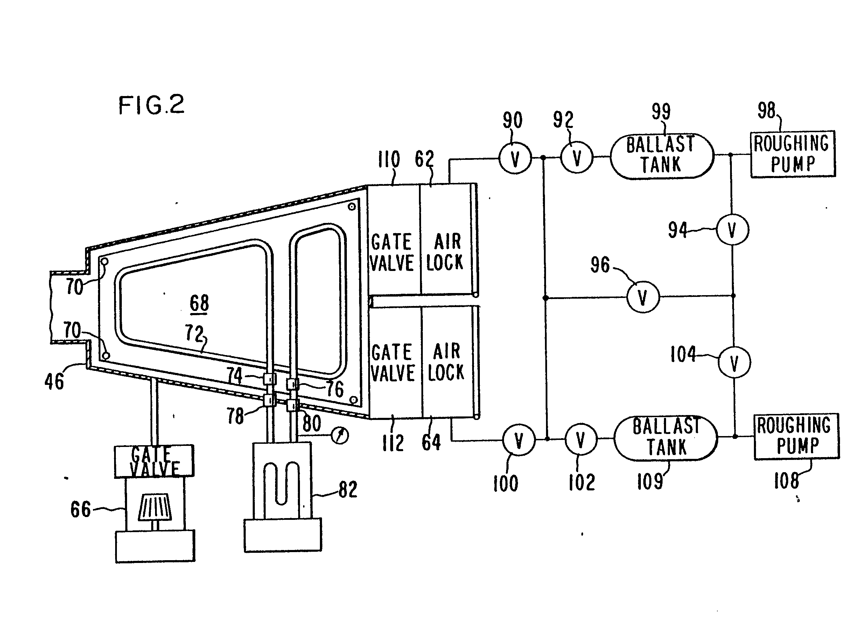

FIG. 2 is a schematic illustration of the vacuum system of the processing chamber of the present invention.

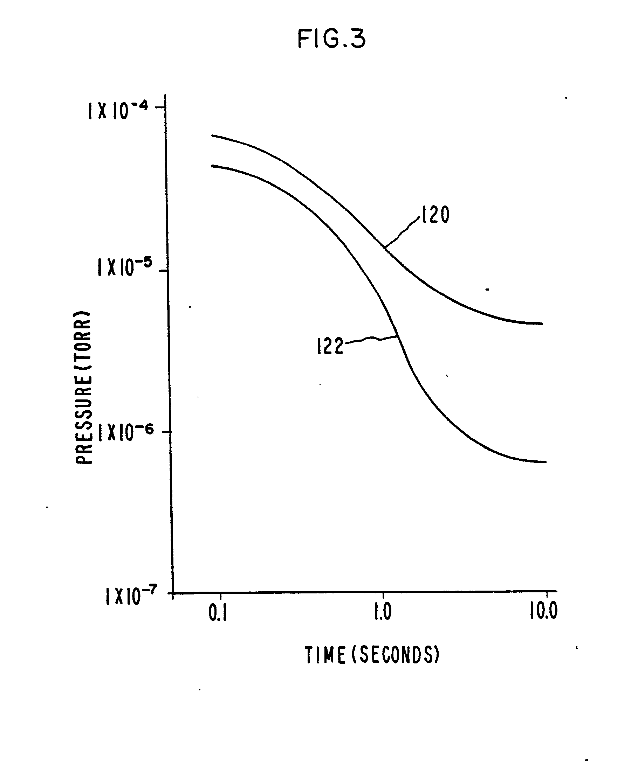

FIG. 3 is a comparison of measured performance with and without the cryo-panel of the present invention.

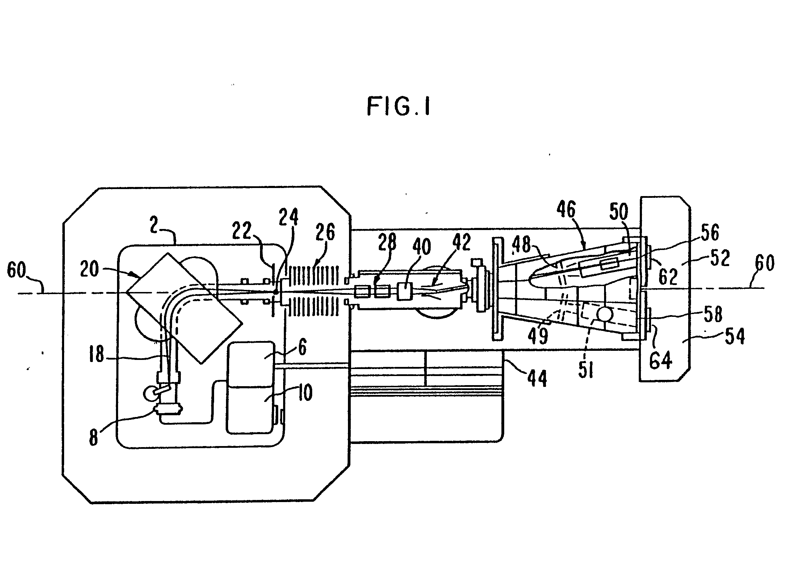

The context of the present invention is best described with the aid of FIG. 1 which illustrates a typical ion implantation system. A high voltage terminal 2 is maintained at a selectable potential of +10 kev to +200 kev, typically, with respect to ground. Within the terminal 2 there is located an ion source 8 and associated power supplies 10, providing extraction, probe and focusing potentials which need not be considered in detail for the present purposes. Typically the ion source operates on a gaseous feed stock requiring gas handling system 6 which may be employed to select among several gas cylinders and to supply the selected gas to the ion source through a controlled leak. A high current ion beam 18 diverging from the ion source 8 is momentum analyzed in analyzer magnet 20 and issues from the magnet defined by aperture 22 and further limited by variable slit system 24. The beam is then accelerated to ground potential in accelerating tube 26. Optical elements 28 such as a quadrupole doublet, operate on the beam to yield a spatial momentum focus at the target planes 56 or 58. The typical system of FIG. 1 utilizes an electrostatic deflection system including y deflection plates 40 and x deflection plates 42 to direct the beam 18 over the selected target plane. The wave forms are developed in scan system 44 for application to the plates 40 and 42 to achieve a desired scanning pattern. A dual channel target chamber 46 is provided to house the workpiece(s) subject to processing. Included in the target chamber are beam defining slits 48 and 49 for the respective processing channels and Faraday cages 50 and 51 for charge collection and integration. An automatic wafer handling system including feed channels 52 and 54 service the two processing channels for introducing semiconductor wafers, one at a time through each of two vacuum locks for time-staggered introduction into the target chamber. The wafer handling system properly locates, aligns, cools the wafer during processing and removes the processed wafer from the chamber at the conclusion of processing. The wafer handling system is described in copending European application EP—A—0095368 based on U.S. Serial No. 381,085.

It is understood that the entire region traversed by the ion beam is maintained at high vacuum, e.g., typically, pressures of the order of $1.33 \times 10^{-4}$ Pa ($10^{-6}$ mm.Hg).

The target chamber 46 comprises a generally trapezoidal section in the plane of the deflected beam to accommodate either of two alternative trajectories terminating at two respective end stations 62 and 64. Beam deflection apparatus, not shown, is housed upstream of the target chamber 46 as indicated in FIG. 1 and is understood to impose a desired central trajectory on the ion beam. A conventional high vacuum pumping port, preferably located on the floor of the chamber, communicates with a high vacuum pump 66. A 15 cm cryopump, Model VK12A, has been used to obtain a baseline pressure of $53.2 \times 10^{-6}$ Pa ($4 \times 10^{-7}$ Torr) under production cycle conditions. The cryopanel 68 is disposed parallel to the top surface of the chamber, and mechanical mounting is secured in straightforward fashion through mechanical insulating standoff 70 to maintain electrical isolation of the cryo-panel from the chamber. The cryo-panel is typically constructed of 3 mm gauge stainless steel to which there is brazed a refrigerant circulation channel 72, preferably formed from stainless steel tubing of 6 mm i.d. The surface of the panel is then electropolished and the refrigerant channel 72 is terminated in electrically isolated couplings 74 and 76 which in turn communicate through vacuum feedthroughs 78, 80 to a refrigeration system 82. Satisfactory results have been obtained in the present system using a Polycold PCT—200® refrigeration system available from Polycold, Inc., San Rafael, California. This refrigeration system circulates refrigerant in channel 72 to maintain the cryo-panel in the range −125°C to −150°C. The physical size of the target chamber permits a large area cryo-panel. In one system the area of the cryo-panel occupies 0.2 square metres, e.g., 0.4 square metres total surface area. At a temperature of −130°C, the cryo-panel 68 achieves a pumping speed in excess of 10,000 liters per second and is believed to reach pumping speeds as high as 20,000 liters per second for water vapor introduced into the chamber with the wafers.

Electrical isolation of the cryo-panel permits a partial charge collection function to be served. The charge collection is independently derived from the wafer platen under ion bombardment and from other charge collection surfaces disposed within chamber 46. The collected charge for the several electrically isolated surfaces is then summed for a measure of the total beam current into the chamber.

A two-stage roughing cycle is employed for efficient pumpdown according to the scheme briefly described below. The wafer is secured to the platen at a given end station, for example 62, and after an interval of 0.2 seconds, valves 90 and 92 are opened to the first stage pumping of the roughing cycle. (Actuation of all valves in the process cycle is under control of a synchronization interlock logic system which monitors pressure conditions and other variables of the system. Such logic systems are well known and need not be discussed in detail.) Valves 94 and 96 remain closed with the result that the end station is evacuated by roughing pump 98 through expansion tank 99. Approximately 1/10 second is employed for this first stage pumping. The first stage is then valved off by valve controllers operating to close valve 92; after approximately 0.2 seconds, the second stage roughing pump and expansion tank is placed in open communication with the end station by opening valve 102. The latter pump reduces the pressure to approximately 26.6 Pa (200 microns of Hg) within an interval of approximately 0.3 seconds; after 0.2 seconds, the roughing valve 90 and the second stage valve 102 have been closed and the high vacuum valve 110 opens to expose the wafer at end station 62 to the processing chamber 46. The expansion tanks 99 and 109 are continuously evacuated by the respective pumps 98 and 108 to augment the pumping efficiency within the constraints of a fixed duty cycle. This augmenting of the pumping efficiency is discussed in greater detail in copending European application EP—A—0095369 based on U.S. Serial No. 381,289. Valves 94, 104 and 106 allow evacuation of inter-valve regions, e.g., valves 92—94 in straightforward fashion. Further vacuum plumbing, which need not be discussed, permits the roughing pumps to be applied to other requirements outside the processing cycle.

The description in terms of a large area panel for water vapor cryopumping is not limiting as to that form. One will readily note the utility of equivalent surface area cryopumping within the target chamber region to accomplish the objective.

Although the discussion of the invention has been given in the context of an ion implanter, one will readily understand the invention is beneficial for any similar high vacuum process for which the workpiece is introduced from ambient condition and for which high throughput is a prime desiderata. Therefore, the invention should not be restricted to the described embodiments, but rather, should be limited only by the scope of the appended claims.

## Claims

1. A processing system for charged particle radiation treatment of a plurality of workpieces in series, said workpieces being loaded from ambient pressure to said processing system at high vacuum, comprising:
means for generating a charged particle beam for irradiating each said workpiece; and
a processing chamber and means for serially introducing each said workpiece into said processing chamber, said processing chamber further comprising first pumping means to reduce the pressure of residual gases in said processing chamber to less than a preselected upper limit within a preselected time interval, and second pumping means concurrently operative with said first pumping means for removing water vapour within said processing chamber to reduce its partial pressure to less than a preselected upper limit within said preselected time interval, said second pumping means comprising at least one cooled surface electrically isolated from said processing chamber to form at least part of a charge collection cage for measurement of said charged particle beam, and means for refrigerating said cooled surface.

2. A system as claimed in claim 1 wherein said means for refrigerating said cooled surface includes a coolant channel in thermal communication with said cooled surface, a coolant for circulating in said channel and means for maintaining said coolant in a predetermined temperature range.

3. A system as claimed in claim 1 adapted for serial processing of semiconductor wafers.

4. A system as claimed in claim 3 wherein said means for refrigerating said cooled surface maintains it in the temperature range of −125°C to −150°C.

5. A system as claimed in any one of claims 1 to 4, wherein said cooled surface has sufficient area to achieve a pumping speed of at least 10,000 litres per second for water vapour.

## Patentansprüche

1. Bearbeitungsanlage zur Bestrahlung einer Vielzahl aufeinanderfolgender Werkstücke mit geladenen Teilchen, wobei die Werkstücke vom Umbebungsdruck in die mit Hochvakuum versehene Bearbeitungsanlage gebracht werden, und folgendes umfasst:
Mittel zur Erzeugung eines Strahlenbündels aus geladenen Teilchen zur Bestrahlung jedes genannten Werkstückes, und eine Bearbeitungskammer und Mittel zur aufeinanderfolgenden Einführung jedes genannten Werkstückes in die genannte Bearbeitungskammer, wobei die genannte Bearbeitungskammer ferner ein erstes Pumpmittel zur Reduktion des Druckes der in der genannten Bearbeitungskammer verbleibenden Gase innerhalb einer vorgewählten Zeitspanne bis unterhalb einer vorgewählten Obergrenze und ein zweites, mit dem ersten genannten Pumpmittel gleichzeitig arbeitendes Pumpmittel zur Entfernung des Wasserdampfes innerhalb der genannten Bearbeitungskammer innerhalb der genannten vorgewählten Zeitspanne zur Verringerung des Partialdruckes derselben bis unterhalb einer vorgewählten Obergrenze enthält, wobei das zweite Pumpmittel wenigstens eine von der genannten Bearbeitungs-

**EP 0 095 367 B1**

kammer elektrisch isolierte, gekühlte Oberfläche, die wenigstens einen Teil eines Ladungsfangkäfigs bildet, zur Messung des genannten Strahlenbündels aus geladenen Teilchen und Mittel zur Tiefkühlung der genannten gekühlten Oberfläche aufweist.

2. Bearbeitungsanlage nach Anspruch 1, in der die genannten Mittel zur Tiefkühlung der genannten gekühlten Oberfläche einen mit der genannten gekühlten Oberfläche in thermischer Verbindung befindlichen Kühlmittelkanal, ein Kühlmittel zum Durchlaufen des genannten Kanals und Mittel zum Halten des genannten Kühlmittels in einem vorgewählten Temperaturbereich enthalten sind.

3. Bearbeitungsanlage nach Anspruch 1, die an die aufeinanderfolgende Bearbeitung von Halbleiterplättchen angepasst ist.

4. Bearbeitungsanlage nach Anspruch 3, in der die Mittel zur Tiefkühlung der genannten Oberfläche dieselbe in einem Temperaturbereich von −125°C bis −150°C halten.

5. Bearbeitungsanlage nach einem der Ansprüche 1—4, in der die gekühlte Oberfläche eine zum Erreichen einer Pumpgeschwindigkeit von mindestens 10'000 Liter/sec. Wasserdampf ausreichende Fläche aufweist.

**Revendications**

1. Système de traitement pour traitement par irradiation par particules chargées d'une multiplicité de pièces à traiter en série, lesdites pièces à traiter étant introduites en venant de la pression ambiante dans ledit système de traitement sous vide poussé, comprenant:

des moyens de génération d'un faisceau de particules chargées pour irradier chacune desdites pièces à traiter; et une chambre de traitement et des moyens d'introduction en serie de chacune desdites pièces à traiter dans ladite chambre de traitement, ladite chambre de traitement comprenant en outre un premier moyen de pompage propre à réduire la pression des gaz résiduels dans ladite chambre de traitement à une valeur inférieure à une limite supérieure présélectionnée en un intervalle de temps présélectionné, et un deuxième moyen de pompage agissant concurrement audit premier moyen de pompage de manière à extraire la vapeur d'eau dans ladite chambre de traitement afin de réduire sa pression partielle à une valeur inférieure à une limite supérieure présélectionnée dans ledit intervalle de temps présélectionné, ledit deuxième moyen de pompage comprenant au moins une surface refroidie électriquement isolée de ladite chambre de traitement pour former au moins une partie d'une cage de collecte de charge pour la mesure dudit faisceau de particules chargées, et un moyen de réfrigération de ladite surface refroidie.

2. Système selon la revendication 1 dans lequel ledit moyen de réfrigération de ladite surface refroidie comporte un canal de réfrigérant en communication thermique avec ladite surface refroidie, un agent réfrigérant destiné à circuler dans ledit canal et des moyens de maintien dudit agent réfrigérant dans une gamme de températures prédéterminée.

3. Système selon la revendication 1 adapté au traitement en série de tranches de semiconducteur.

4. Système selon la revendication 3 dans lequel ledit moyen de réfrigération de ladite surface refroidie maintient celle-ci dans la gamme de températures de −125 à −150°C.

5. Système selon l'une quelconque des revendications 1 à 4, dans lequel ladite surface refroidie présente une aire suffisante pour assurer une vitesse de pompage d'au moins 10 000 litres par seconde pour la vapeut d'eau.

5

FIG.I

FIG.2

EP 0 095 367 B1

## FIG.3